# FASCICULE DE BREVET EUROPEEN

(11) **EP 3 167 247 B1**
(45) Date de publication et mention de la délivrance du brevet: **07.11.2018**
(21) Numéro de dépôt: 15732595.2
(22) Date de dépôt: 23.06.2015
(51) Int. Cl.: G01D 5/14, G01C 17/38, G01R 33/00, G01D 18/00

(54) **DISPOSITIF DOMOTIQUE ET PROCÉDÉ DE DÉTECTION DE LA POSITION D'UN OBJET À CALIBRATION AUTONOME**
SELBSTKALIBRIERENDE DOMOTIKVORRICHTUNG UND VERFAHREN ZUR DETEKTION DER POSITION EINES OBJEKTS
SELF-CALIBRATING HOME AUTOMATION DEVICE AND METHOD FOR DETECTING THE POSITION OF AN OBJECT

(30) Priorité: 07.07.2014 FR 1456523
(43) Date de publication de la demande: 17.05.2017
(73) Titulaire: Somfy Protect by Myfox, 31670 Labège (FR)
(72) Inventeur: PRUNET, Jean-Marc, F-75007 Paris (FR); FOURNIOLS, Jean-Yves, F-31130 Quint-Fonsegrives (FR)
(74) Mandataire: Lavoix
(86) Numéro de dépôt international: PCT/EP2015/064092
(87) Numéro de publication internationale: WO 2016/005182

(56) Documents cités:
- EP-A2- 1 300 651
- EP-A2- 1 832 889
- US-A- 5 297 063
- US-A1- 2007 250 262
- US-A1- 2013 000 406
- US-B2- 6 940 405

## Description

L'invention concerne un dispositif domotique permettant de détecter la position d'un objet surveillé de façon fiable. L'invention permet notamment de calibrer un tel dispositif de façon simple et fiable pour tout type d'objet surveillé, y compris un ouvrant tel qu'une porte ou une fenêtre.

La surveillance de la position d'un ouvrant est essentielle dans un dispositif de domotique, et notamment dans un dispositif d'alarme contre les intrusions et les effractions. On souhaite plus particulièrement être informé de la position de l'ouvrant par rapport à une orientation de référence - généralement une position fermée sur un dormant.

US 6,940,405 décrit un système d'alarme qui comprend un détecteur incluant un magnétomètre pour détecter la position de l'ouvrant. La position d'un objet pivotant peut être détectée par détection d'un changement d'orientation de l'objet grâce au capteur de champ magnétique dans le champ magnétique terrestre d'orientation globalement fixe localement. Le document US20130000406 décrit également un dispositif selon l'état de la technique. Cependant ces dispositifs connus ne permettent pas de connaître la position instantanée d'un ouvrant par rapport à un dormant. En effet, les mesures de capteurs de champ magnétique sont généralement peu fiables et sont influencés par de nombreux champs magnétiques parasites - notamment par des variations locales du champ magnétique. À titre d'exemple, de tels détecteurs fonctionnent généralement sans fil et comportent donc à ce titre une pile. Or les métaux contenus dans la pile peuvent influencer de façon permanente la mesure du champ magnétique. De même si un détecteur de position d'un dispositif domotique selon l'invention est disposé sur une porte à chambranle métallique, le champ magnétique terrestre local est perturbé de façon non-homogène.

De nombreux autres éléments peuvent modifier le champ magnétique local mesuré par le détecteur, au point de le rendre, sinon inopérant, à tout le moins peu précis.

Des capteurs plus complexes et aussi beaucoup plus coûteux et volumineux permettraient de s'affranchir de ces limites. Cependant, de tels détecteurs ne sont donc pas adaptés à un dispositif domotique dans lequel les détecteurs doivent être le plus discrets et légers possible, tout en restant de coût raisonnable et à basse consommation énergétique pour être autonome.

Il est donc nécessaire de s'affranchir de ces perturbations magnétiques.

Ce problème est parfois résolu, (exemple des boussoles dans les smart phones) en faisant faire une rotation de 360degrés au capteur afin d'explorer tout le plan.

Or, dans un dispositif domotique, deux contraintes ne permettent pas d'explorer sur 360° le plan :
- la calibration doit s'effectuer à l'endroit du capteur,
- dans l'exemple d'un ouvrant tel qu'une porte on ne peut pas effectuer plus de 90 degrés.

L'espace de mouvement de l'ouvrant ne couvrant jamais les 360 degrés de rotation et dans la plupart des cas se réduisant à maximum 90 degrés, on se retrouve sans aucune information extérieure sur la position de l'arc dans lequel l'ouvrant est déplacé qui est fonction de l'alignement au nord magnétique de l'ouvrant et des parasites magnétiques.

L'invention vise donc à pallier ces inconvénients.

L'invention vise à proposer un dispositif domotique permettant de mesurer de façon précise et fiable la position d'un ouvrant.

L'invention vise notamment à proposer un dispositif domotique permettant de s'affranchir de perturbations locales du champ magnétique.

Elle vise en particulier à proposer un dispositif domotique dans lequel un magnétomètre est calibré automatiquement pour s'affranchir des effets des perturbations du champ magnétique local sur la détermination de l'orientation, et plus particulièrement de la variation d'orientation du magnétomètre. Elle vise en particulier à ce titre à permettre une telle calibration sans imposer des manipulations spécifiques à l'utilisateur ni le déplacement de l'objet surveillé dans des positions de référence prédéterminées.

Elle vise plus particulièrement à proposer un dispositif domotique comprenant un magnétomètre est permettant de détecter la position d'objets surveillés tels que des ouvrants pour lesquels il n'est pas possible de calibrer le magnétomètre en lui faisant effectuer une rotation complète par rapport à la direction principale du champ magnétique local.

L'invention vise également à proposer un tel dispositif qui soit peu volumineux, peu coûteux, et malgré tout fiable.

L'invention vise à proposer un dispositif à faible consommation énergétique, et qui puisse donc être autonome.

L'invention vise également à proposer un tel dispositif qui soit simple d'usage, et notamment qui ne requière que peu ou pas d'opérations de la part de l'installateur et de l'utilisateur.

L'invention concerne donc un dispositif domotique selon la revendication 1.

L'invention s'applique avantageusement aux objets surveillés pivotants au moins pour partie dans un plan azimutal, c'est-à-dire pivotants par rapport au champ magnétique terrestre. Ainsi, la variation de l'orientation de l'ouvrant par rapport au champ magnétique terrestre permet de déterminer sa position angulaire. L'invention est donc particulièrement avantageuse pour surveiller la position d'ouvrants pivotants (ou battants) tels que des portes ou des fenêtres par rapport à un dormant.

Néanmoins, l'invention peut aussi s'appliquer à des objets coulissants, notamment des ouvrants coulissants. Dans ce cas un dispositif domotique selon l'invention comprend en outre avantageusement un aimant permanent adapté pour pouvoir être disposé sur objet fixe par rapport audit objet surveillé. Par exemple un tel aimant permanent peut être fixé sur un cadre dormant d'un ouvrant de sorte que le coulissement du détecteur de position avec l'ouverture ou la fermeture de l'ouvrant modifie l'orientation du champ magnétique créé par ledit aimant permanent par rapport au détecteur de position, en fonction de la position en translation du détecteur de position.

L'invention permet de calibrer un détecteur de position, notamment un magnétomètre d'un détecteur de position en fonction du champ magnétique local sans intervention de l'installateur ou de l'utilisateur. La procédure de calibration mise en oeuvre par ledit détecteur de position est entièrement automatique.

L'invention permet de calibrer le détecteur de position en actualisant une valeur, dite valeur de calibration, en fonction du champ magnétique local.

L'invention permet plus particulièrement d'adapter ladite valeur de calibration en fonction d'un champ magnétique local distinct (d'intensité et/ou d'orientation distincte(s)) du champ magnétique terrestre attendu. L'invention permet donc à un dispositif domotique de fonctionner de façon fiable, notamment de déterminer de façon fiable l'orientation instantanée d'un objet surveillé, bien que le champ magnétique local soit perturbé.

Un dispositif selon l'invention permet donc de corriger des perturbations constantes du champ magnétique local. Plus particulièrement, un dispositif selon l'invention permet de supprimer des perturbations constantes du champ magnétique local induites par des éléments liés à l'objet surveillé, et qui se déplacent donc avec lui.

L'invention permet aussi de corriger des perturbations influant sur le champ magnétique (notamment sur l'intensité et/ou l'orientation du champ magnétique) de façon variable en fonction de l'orientation du détecteur de position.

Par exemple, lorsque le champ magnétique de référence pour la mesure de la position de l'objet surveillé est le champ magnétique terrestre, par une rotation d'un objet surveillé de 180° le champ magnétique mesuré selon un axe de mesure dans le plan azimutal passe par une valeur maximale et par une valeur nulle. Or, si la valeur minimale ainsi mesurée est différente de zéro, c'est qu'il existe une perturbation locale du champ magnétique terrestre. La calibration du détecteur par le remplacement de ladite valeur de calibration en mémoire permet de prendre en compte de telles perturbations dans les mesures de champ magnétique, et donc dans les mesures de position de l'objet surveillé.

De même, si la norme du vecteur champ magnétique local est très supérieure ou très inférieure, et/ou varie fortement en fonction de l'orientation du détecteur de position, par rapport à la valeur moyenne du champ magnétique terrestre, cela montre que le champ magnétique local est perturbé par rapport au seul champ magnétique terrestre.

La pluralité de valeurs d'intensité comprend au moins deux valeurs d'intensité obtenues pour deux positions distinctes de l'objet surveillé. Sauf dans des cas très particuliers, les valeurs d'intensité du champ magnétique local selon un même axe de mesure sont distinctes pour deux positions distinctes du détecteur de position.

Cependant, avantageusement et selon l'invention, la pluralité de valeurs d'intensité comprend au moins trois valeurs d'intensité selon un même axe de mesure, obtenues pour trois positions distinctes de l'objet surveillé.

Dans le cas particulier d'un objet surveillé qui est un ouvrant, une pluralité de mesures de l'intensité du champ magnétique local est réalisée pendant l'ouverture de l'ouvrant.

Avantageusement et selon l'invention, le magnétomètre fournit des données numériques.

Avantageusement et selon l'invention, le dispositif comprend une mémoire adaptée pour pouvoir enregistrer des données représentatives d'au moins deux valeurs d'intensité distinctes du champ magnétique local. Plus particulièrement, lorsque le magnétomètre est un magnétomètre trois axes, la mémoire est adaptée pour pouvoir enregistrer des données représentatives d'au moins trois valeurs de calibration, soit une valeur de calibration pour chaque axe de mesure.

L'unité de traitement est avantageusement adaptée pour traiter des données numériques. L'unité de traitement est avantageusement adaptée pour pouvoir lire et écrire des données dans ladite mémoire.

L'unité de traitement est avantageusement programmable, ou adaptée pour pouvoir lire des instructions de programme.

Dans un dispositif selon l'invention, ladite valeur constante déterminée au cours d'une étape de calibration remplace la valeur de calibration enregistrée en mémoire. La valeur constante devient donc la nouvelle valeur de calibration et est enregistrée en tant que telle en mémoire.

Avantageusement et selon l'invention, l'unité de traitement est programmée pour pouvoir calculer une valeur constante pour chaque axe de mesure au moins en fonction d'une pluralité de valeurs d'intensité d'un champ magnétique local sur cet axe de mesure.

Avantageusement et selon l'invention, l'unité de traitement est programmée pour pouvoir calculer une valeur constante pour chaque axe de mesure au moins en fonction d'une pluralité de valeurs d'intensité correspondant à l'intensité d'un champ magnétique local mesurée selon chaque axe de mesure pour une pluralité de positions du détecteur de position.

Avantageusement et selon l'invention, ladite valeur constante est, pour un axe de mesure, égale à la somme:
- de la moyenne de la valeur d'intensité la plus basse et de la valeur d'intensité la plus haute de la pluralité de valeurs d'intensité fournies par le magnétomètre, pour cette axe de mesure, pour une pluralité de positions distinctes du boîtier, et
- de la valeur de calibration enregistrée en mémoire pour cet axe de mesure.

La valeur de calibration peut être négative, nulle ou positive.

Avantageusement, un dispositif selon l'invention est aussi caractérisé en ce que l'unité de traitement est programmée pour systématiquement calculer une valeur, dite valeur corrigée, par soustraction de la valeur de calibration à ladite valeur d'intensité instantanée fournie par ledit magnétomètre.

Un dispositif selon l'invention présente donc l'avantage de pouvoir déterminer l'orientation et/ou la position du détecteur de position, et donc d'un objet surveillé, en s'affranchissant de perturbations du champ magnétique, qu'elles soient indépendantes de la position du détecteur de position ou dépendante de l'angle formé entre le champ magnétique local et le détecteur de position.

L'unité de traitement calcule ladite valeur constante en fonction de la valeur de calibration et d'une pluralité de valeurs d'intensité fournies par le magnétomètre pour une pluralité de positions distinctes du boîtier. Plus particulièrement, ladite valeur constante est avantageusement calculée en fonction desdites valeurs corrigées.

Avantageusement et selon l'invention, chaque valeur du champ magnétique peut être représentée, traitée et enregistrée sous forme vectorielle, notamment les valeurs d'intensité, ladite valeur constante, ladite valeur de calibration, les valeurs corrigées, etc. Chaque terme du vecteur correspond avantageusement à une valeur d'intensité d'un champ magnétique selon un axe de mesure.

Avantageusement et selon l'invention, le magnétomètre est adapté pour pouvoir mesurer des variations du champ magnétique terrestre local par une rotation du détecteur de position dans un plan azimutal.

Un tel détecteur de position est donc particulièrement adapté à la détection de l'orientation du détecteur de position, donc d'un objet surveillé dans le plan azimutal. Il est donc plus particulièrement adapté à la mesure de la position angulaire d'un ouvrant pivotant autour d'un axe vertical. En particulier, un tel détecteur de position permet de déterminer l'état ouvert ou fermé de l'ouvrant sans nécessiter de fixer un second dispositif générateur de champ magnétique au dormant de l'ouvrant.

À cet effet, avantageusement et selon l'invention, le magnétomètre est un magnétomètre trois axes adapté pour fournir des signaux représentatifs de la valeur d'intensité instantanée du champ magnétique local selon trois axes de mesure orthogonaux, fixes par rapport au boîtier du détecteur de position.

Ainsi, quelle que soit l'orientation du détecteur de position par rapport à l'objet surveillé et donc quelle que soit l'orientation du détecteur de position par rapport au champ magnétique local, le détecteur de position est en mesure de détecter des variations d'intensité du champ magnétique local sur au moins l'un des trois axes de mesure, lorsque la position de l'objet surveillé est modifiée.

En particulier, un magnétomètre trois axes permet de calculer la norme et l'orientation du vecteur champ magnétique local.

Ainsi, avantageusement et selon l'invention, une valeur constante est calculée et enregistrée en mémoire en tant que valeur de calibration pour chacune des trois directions fixes du boîtier qui représentent chacune un axe de mesure du magnétomètre ; c'est-à-dire qu'un vecteur de valeur de calibration comprenant trois composantes est enregistré en mémoire.

Par ailleurs, un dispositif selon l'invention comprend avantageusement en outre un accéléromètre fixé au boîtier et adapté pour fournir des signaux, dits signaux d'accélération, représentatifs de l'accélération du boîtier selon au moins un axe de mesure.

La présence d'un accéléromètre en plus du magnétomètre permet de donner à un détecteur selon l'invention de nombreuses autres fonctions.

En particulier, l'accéléromètre permet de déterminer un plan de rotation d'un objet surveillé, et ainsi de choisir les axes de mesures du magnétomètre.

Avantageusement et selon l'invention, le détecteur de position comprend en outre des moyens d'émission sans fil de signaux.

Plus particulièrement, le détecteur de position comprend avantageusement des moyens d'émission sans fil de signaux selon un protocole de communication sans fil de proximité, par exemple selon un protocole de communication Wifi®, ou longue distance, par exemple selon un protocole de communication GSM, GPRS, UMTS.

Ainsi, dans certains modes de réalisation de l'invention, chaque détecteur de position est adapté pour pouvoir émettre directement des signaux formant des messages d'état à une antenne distante d'un réseau de télécommunication de longue distance. Cette variante est utile notamment lorsque le dispositif domotique selon l'invention est dépourvu d'unité centrale collectant les signaux de chaque détecteur de position selon l'invention.

Ladite mémoire est en outre adaptée pour pouvoir stocker des données représentatives de l'état d'un ouvrant. Ainsi, un détecteur de position selon l'invention est adapté pour conserver en mémoire l'état "fermé", "ouvert" et/ou "en mouvement" d'un ouvrant.

Avantageusement et selon l'invention, le détecteur de position est adapté pour pouvoir élaborer et émettre sans fil des signaux représentatifs de l'orientation du détecteur de position, notamment d'un changement d'orientation du détecteur de position, et plus particulièrement d'un changement d'état ("fermé", "ouvert" par exemple) de l'objet surveillé.

L'unité de traitement de chaque détecteur de position est adaptée pour pouvoir émettre des messages, dit messages d'état, représentatifs de l'orientation au moins d'un ouvrant surveillé auquel ledit détecteur de position est fixé. Les messages d'état sont plus généralement représentatifs de l'état dudit ouvrant par rapport à son dormant. Par exemple, l'unité de traitement du détecteur de position est adaptée pour envoyer des messages d'état représentatifs d'un état "ouvert", d'un état "fermé", ou d'un état "en mouvement" de l'ouvrant.

De plus, un dispositif selon l'invention comprend avantageusement en outre une unité centrale adaptée pour recevoir sans fil des signaux émis par un détecteur de position.

L'unité centrale est par exemple une unité centrale d'alarme. Néanmoins, conformément à l'invention ladite unité centrale peut avoir d'autres fonctions telles que gérer la température d'un local (en connaissant l'état des ouvrants de ce local), aider à la surveillance de personnes dans un local (enfants, personnes âgées, ...), etc.

Le détecteur de position est adapté pour pouvoir communiquer avec la centrale d'alarme, notamment pour envoyer au moins un signal représentatif d'un état ouvert ou fermé d'un ouvrant sur requête par l'unité centrale.

Ainsi, une pluralité de détecteurs de position peut être disposée dans un local à surveiller, et l'unité centrale reçoit et traite des messages d'état émis par chaque détecteur de position.

L'invention concerne aussi un procédé de calibration d'un détecteur de position d'un objet tel que décrit dans la revendication 9.

Avantageusement, dans un procédé selon l'invention l'unité de traitement enregistre en mémoire des valeurs d'intensité pour une pluralité de positions du boîtier, et ne calcule ladite valeur constante que lorsqu'au moins trois valeurs d'intensité sont distinctes entre elles d'au moins une valeur prédéterminée, dite valeur de balayage.

Avantageusement et selon l'invention, l'unité de traitement calcule ladite valeur constante à partir au moins desdites trois valeurs d'intensité distinctes entre elles d'au moins ladite valeur seuil de balayage.

Plus particulièrement, lorsque le magnétomètre mesure l'intensité du champ magnétique local selon plusieurs axes de mesure, l'unité de traitement calcule ladite valeur constante dès qu'au moins trois mesures présentent selon chaque axe de mesure des valeurs d'intensité selon ledit axe de mesure, distinctes entre elles d'au moins ladite valeur de balayage. Ainsi le critère de différence entre valeurs d'intensité d'au moins ladite valeur de calibrage doit être vérifié selon chaque axe de mesure pour que l'unité de traitement calcule ladite valeur constante et utilise ces mesures pour calculer ladite valeur constante.

Ladite valeur de balayage est avantageusement choisie comprise entre 20 % et 40 %, plus particulièrement entre 25 % et 35 %, de préférence de l'ordre de 30 %, de l'intensité moyenne du champ magnétique terrestre (qui est de l'ordre de 5. 10⁻⁵ T).

Avantageusement et selon l'invention, dans un procédé selon l'invention :
- ledit magnétomètre effectue des mesures de l'intensité du champ magnétique selon au moins deux axes, dites axes de mesure, fixes distincts du boîtier,
- l'unité de traitement calcule une valeur constante pour chaque axe de mesure en résolvant au moins deux équations dont les deux inconnues sont lesdites valeurs constantes.

Dans un procédé selon l'invention, avantageusement, ledit détecteur de position comprenant un accéléromètre délivrant des signaux représentatifs de l'accélération du boîtier selon trois axes de mesures distincts, ledit magnétomètre effectuant des mesures de l'intensité du champ magnétique selon trois axes de mesure et ledit objet surveillé étant pivotant dans le référentiel terrestre, l'unité de traitement détermine à partir des signaux de l'accéléromètre les deux axes de mesure du magnétomètre dont les mesures doivent être utilisés pour déterminer la position de l'objet surveillé.

Plus particulièrement, l'unité de traitement détermine, à partir des signaux de l'accéléromètre, la direction de la gravité terrestre, et détermine les deux axes de mesures du magnétomètre qui sont orthogonaux à la direction de la gravité terrestre. Ainsi l'unité de traitement détermine le plan azimutal. Or dans le cas d'un objet surveillé tel qu'une porte ou une fenêtre battante, ceux-ci se déplacent en rotation dans le plan azimutal, qui est aussi le plan dans lequel une détection de position (ou d'orientation) par rapport au champ magnétique terrestre est la plus fiable. Il est donc particulièrement avantageux, dans la plupart des applications courantes, notamment de domotique et plus particulièrement d'alarmes, de réaliser des mesures magnétométriques dans le plan azimutal.

En outre, avantageusement, dans un procédé selon l'invention l'unité de traitement :
- calcule, pour une pluralité de positions distinctes du boîtier, une valeur, dite valeur de norme, à partir des valeurs d'intensité selon chaque axe de mesure pour cette position, et de la valeur de calibration,
- compare ladite norme à au moins une valeur de seuil prédéterminée enregistrée en mémoire.

Cela correspond à une vérification de la validité de chaque valeur de calibration basée sur le calcul de la norme du vecteur champ magnétique tel que mesuré par ledit magnétomètre puis corrigé par soustraction des valeurs de calibration aux valeurs d'intensité sur chaque axe de mesure du vecteur champ magnétique. La norme du vecteur champ magnétique mesuré et corrigé est ensuite comparée à au moins une valeur seuil prédéterminée.

Ladite valeur de seuil est avantageusement comprise entre 0,5 fois et 2 fois l'intensité de la valeur moyenne du champ magnétique terrestre à la surface de la Terre, soit entre 0,5 fois et 2 fois une valeur de 5.10⁻⁵ Teslas.

Avantageusement, ladite valeur de norme est comparée à au moins deux valeurs de seuil. L'unité de traitement détermine ainsi si la valeur de norme est comprise dans une plage de valeurs prédéterminée. La première valeur de seuil (borne inférieure de la plage) est avantageusement comprise entre 0,5 et 1, notamment de l'ordre de 0,9, et la deuxième valeur de seuil (borne supérieure de la plage) est avantageusement comprise entre 1 et 2, notamment de l'ordre de 1,7. Avantageusement, un procédé selon l'invention comprend:
- une étape de fixation du boîtier du détecteur de position audit objet surveillé,
- une étape de déplacement de l'objet surveillé lors de laquelle une pluralité de valeurs d'intensité fournies par le magnétomètre sont enregistrées pour une pluralité de positions distinctes du boîtier.

Lors de l'étape de déplacement de l'objet surveillé, les valeurs d'intensité mesurées pendant ce déplacement doivent être éloignées entre elles d'au moins ladite valeur de balayage pour que l'unité de traitement amorce la calibration du magnétomètre, notamment pour que l'unité de traitement calcule ladite valeur constante.

L'invention s'étend à un programme d'ordinateur comprenant des instructions de code de programme pour l'exécution des étapes d'un procédé selon l'invention lorsque le programme est exécuté sur un ordinateur, notamment sur un dispositif selon l'invention.

L'invention s'étend en particulier à un programme informatique comprenant des instructions pour l'exécution d'un procédé conforme à l'invention lorsque le programme est exécuté par un dispositif comprenant au moins une unité de traitement, notamment par un dispositif conforme à l'invention.

L'invention s'étend à un support d'enregistrement sur lequel est enregistré un programme selon l'invention, ainsi qu'à un dispositif dans lequel un tel programme est enregistré.

Avantageusement, l'unité de traitement comprend au moins une mémoire de programmation contenant des instructions de fonctionnement. Dans certains modes de réalisation, la mémoire de programmation selon l'invention est avantageusement adaptée pour que l'unité de traitement puisse fonctionner selon une pluralité de modes de fonctionnement.

Ainsi, l'unité de traitement peut comprendre un premier mode de fonctionnement, dit mode de calibration, dans lequel elle réalise une série de mesures de l'intensité du champ magnétique local afin de pouvoir calculer ladite valeur constante.

Dans le mode calibration, lorsque l'objet surveillé est un ouvrant, un procédé selon l'invention comprend avantageusement une étape d'ouverture de l'ouvrant. Ainsi, avantageusement, le détecteur effectue une première mesure du champ magnétique local en position fermée, puis une pluralité de mesures pendant l'ouverture de la porte. Lorsque la porte revient en position fermée, le détecteur détermine ladite valeur constante et remplace ladite valeur de calibration en mémoire par ladite valeur constante.

L'invention concerne également un dispositif, un procédé et un programme informatique caractérisés en combinaison par tout ou partie des caractéristiques mentionnées ci-dessus ou ci-après.

D'autres buts, caractéristiques et avantages de l'invention apparaîtront à la lecture de la description suivante donnée à titre non limitatif et qui se réfère aux figures annexées dans lesquelles :
- la figure 1 est une représentation schématique en coupe d'un détecteur de position conforme à l'invention,
- la figure 2 est une représentation schématique de mesures d'intensité d'un champ magnétique terrestre local pour différentes orientations dans le plan azimutal d'un détecteur de position selon la figure 1,
- la figure 3 est un schéma synoptique fonctionnel de la calibration d'un détecteur de position conforme à la figure 1
- la figure 4 est une représentation schématique de mesures d'un champ magnétique terrestre perturbées par un premier type de perturbation,
- la figure 5 est une représentation schématique de mesures d'un champ magnétique terrestre perturbées par un deuxième type de perturbation, avec un premier mode de réalisation de l'invention pour ce deuxième type de perturbation,
- la figure 6 est une représentation schématique de mesures d'un champ magnétique terrestre perturbées par le même type de perturbation que représenté en figure 4, avec un deuxième mode de réalisation de l'invention pour ce deuxième type de perturbation,
- la figure 7 est une représentation schématique de mesures d'un champ magnétique terrestre perturbées par un troisième type de perturbation.

Un détecteur de position 30 d'un dispositif domotique selon l'invention comprend un boîtier 36 dans lequel est disposé un circuit électronique comprenant une unité de traitement 31 de signaux et de données. L'unité de traitement 31 est reliée à un capteur de position formé d'un magnétomètre 34. L'unité de traitement est aussi reliée à un accéléromètre 33. Le circuit électronique sur lequel le magnétomètre 34 et l'accéléromètre 33 sont montés est solidaire du boîtier 36 de sorte que les mesures effectuées par le magnétomètre 34 et l'accéléromètre 33 sont représentatives des déplacements du détecteur de position.

Le détecteur de position 30 comprend des moyens de fixation du boîtier 36 à un objet surveillé, par exemple un socle de fixation pouvant être vissé solidaire d'une porte, ledit boîtier pouvant être engagé de façon solidaire audit support. La calibration du magnétomètre 34 du détecteur de position 30 est par exemple activée par activation d'un capteur de fixation solidaire du boîtier 36 lors de son engagement avec un tel support.

Plus particulièrement, lors de l'activation d'un capteur de fixation solidaire du boîtier 36 lors de son engagement avec un tel support, les signaux du magnétomètre sont acquis à une fréquence plus élevée, par exemple tous les 250ms. Le détecteur de position 20 est avantageusement fixé à la porte avec la porte en position fermée. Ainsi, toutes les mesures de calibration (valeurs d'intensité) sont effectuées lors d'une ouverture de la porte, à partir d'une position fermée de la porte.

Le magnétomètre 34 est un magnétomètre trois axes qui fournit des signaux représentatifs de l'intensité instantanée du champ magnétique local - notamment du champ magnétique terrestre local en absence d'aimants induisant un champ plus intense localement - selon ses trois un axes de mesure, fixes par rapport à un boîtier du détecteur de position.

L'unité de traitement 31 est en outre reliée à une mémoire 32 adaptée pour pouvoir stocker des données numériques, notamment des données représentatives d'au moins trois valeurs de calibration (une pour chaque axe de mesure du magnétomètre 34 au moins), ainsi que des valeurs d'intensité du champ magnétique fournies par le magnétomètre 34, notamment des valeurs d'intensité sous forme de triplet (ou vecteur tridimensionnel) représentatives d'une intensité de champ magnétique sur chaque axe de mesure pour une position donnée du détecteur de position 30. La mémoire 32 peut être du type mémoire vive, mémoire morte, ou avantageusement une combinaison de ces deux types de mémoire.

L'unité de traitement 31 est en outre reliée à une antenne 35 adaptée pour pouvoir émettre des signaux sans fil radiofréquences, par exemple selon le protocole Wifi®.

Le détecteur de position 30 comprend aussi une pile 37 reliée de façon appropriée à chacun des composants du circuit électronique pour les alimenter en énergie électrique.

Le circuit électronique est fixé au boîtier 36, par exemple par des vis 39 ou par des bouterolles.

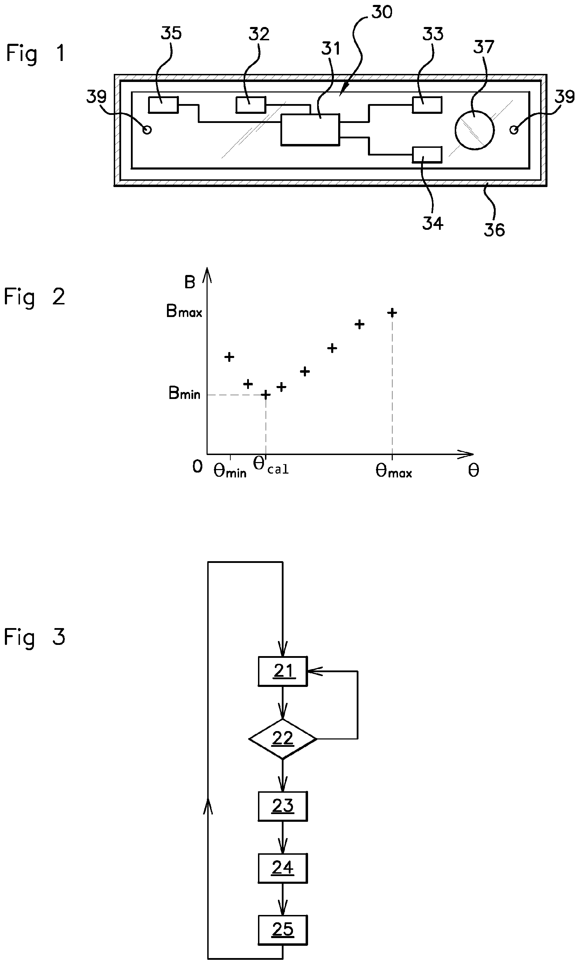

La figure 2 représente une pluralité de valeurs d'intensité du champ magnétique terrestre local B selon un unique axe de mesure, acquises pour différentes orientations θ du détecteur de position (par exemple un détecteur de position 20 tel que décrit ci-dessus et représenté en figure 1). Elles sont par exemple acquises par un détecteur de position fixé à un ouvrant tel qu'une porte.

Lors de l'acquisition les valeurs représentées en figure 2, le détecteur de position 20 a été déplacé entre un angle θmin correspondant à une porte fermée sur son dormant, et un angle θmax dans lequel ladite porte est ouverte.

Dans un détecteur de position 20 selon l'invention, l'unité de traitement 30 soustrait une valeur, dite valeur de calibration, enregistrée dans la mémoire 32 aux mesures effectuées. Les valeurs d'intensité B du champ magnétique local présentées en figure 2 sont donc des valeurs, dites valeurs corrigées.

On s'aperçoit, sur la figure 2, que la pluralité de valeurs corrigées comprend une valeur minimale Bmin pour un angle déterminé θcal et une valeur BMax pour l'angle maximal d'ouverture de la porte lors de la calibration. À l'angle θcal la mesure de Bmin devrait théoriquement être égale au minimum de la projection du champ magnétique terrestre sur l'axe de mesure, et égale à zéro si l'arc balayé est d'au moins 180°. Néanmoins, elle ne l'est pas à cause de perturbations du champ magnétique induite par des éléments qui se déplacent en même temps que le magnétomètre 34 : par exemple la pile 37 du détecteur de position 20, des éléments métalliques dans la porte à laquelle le détecteur de position 20 est fixé (cas par exemple des portes blindées, métalliques, ...), etc.

Une valeur constante, de valeur Bmin perturbe donc l'intensité du champ magnétique selon cet axe de mesure. À condition que la différence entre les valeurs Bmin et BMax soit supérieure en valeur absolue à une valeur de balayage comprise entre 20 % et 40 %, plus particulièrement entre 25 % et 35 %, de préférence de l'ordre de 30 %, de la moyenne de la norme du champ magnétique terrestre (qui est de l'ordre de 5. 10⁻⁵ T), la valeur Bmin est donc avantageusement soustraite à la valeur de calibration, c'est-à-dire que la valeur constante est égale à la valeur Bmin. Ainsi, si les mesures effectuées pour obtenir la figure 2 sont reproduites après une telle modification de la valeur de calibration et si le champ magnétique local n'a pas varié entre temps ou perturbé différemment, un profil de valeurs corrigées très semblable à celui de la figure 2 sera obtenu, à ceci près qu'elles seront toutes plus basses d'une valeur Bmin, de sorte qu'à proximité de l'angle θcal, la valeur corrigée du champ magnétique local devrait être proche d'une valeur correspondant au minimum de la projection du champ magnétique terrestre sur l'axe de mesure (zéro si l'arc balayé est d'au moins 180°). Cette méthode correspond à une technique possible, selon l'invention, de calibration des mesures du magnétomètre 34 d'un détecteur de déplacement 20 selon l'invention, notamment lorsque le magnétomètre est un magnétomètre de mesure selon un seul axe de mesure. D'autres techniques peuvent être envisagées de façon avantageuse et conformément à l'invention, dont certains exemples sont présentés ensuite.

La figure 3 représente un schéma synoptique fonctionnel simplifié de la calibration d'un détecteur de position tel que présenté ci-dessus et en figure 1.

À l'étape 21, l'unité de traitement 31 acquiert des signaux du magnétomètre 34, alors qu'il est déplacé, à des intervalles de temps réguliers, lesdits signaux étant représentatifs de valeurs d'intensité d'un champ magnétique local selon des axes des mesures du magnétomètre 33 pour différentes positions du magnétomètre 34. L'unité de traitement calcule des valeurs, dites valeurs corrigées, par soustraction d'une valeur de calibration enregistrée en mémoire à chacune des valeurs d'intensité acquises. L'unité de traitement stocke en mémoire 32 des données numériques représentatives des valeurs corrigées. Ces valeurs corrigées sont par exemple celles représentées en figure 2 pour un axe de mesure.

L'unité de traitement passe ensuite à l'étape 22.

À l'étape 22, l'unité de traitement 31 compare les valeurs d'intensité enregistrées en mémoire entre elles et compare les différences entre valeurs d'intensité avec une valeur prédéterminée, dite valeur de balayage, enregistrée en mémoire 32. Ainsi, l'unité de traitement recherche des triplets de valeurs de mesure correspondant à une mesure sur trois axes de mesures qui, sur chaque axe de mesure sont distinctes entre elles d'au moins ladite valeur de balayage, enregistrée en mémoire. Ladite valeur de balayage est avantageusement choisie comprise entre 20 % et 40 %, plus particulièrement entre 25 % et 35 %, de préférence de l'ordre de 30 %, de l'intensité moyenne du champ magnétique terrestre projeté sur un axe.

Dès que trois valeurs corrigées distinctes entre elles d'au moins la valeur de balayage sont trouvées, l'unité de traitement passe à l'étape 23, sinon elle poursuit l'étape 21. L'étape 21 et l'étape 22 sont avantageusement menées simultanément par l'unité de traitement 31. Si plus de trois valeurs corrigées distinctes entre elles d'au moins la valeur de balayage sont trouvées, les trois premières valeurs corrigées à répondre à ce critère sont utilisées dans les étapes suivantes.

À l'étape 23, l'unité de traitement 31 détermine, parmi les valeurs d'intensité acquises et enregistrées en mémoire à l'étape 21, la valeur d'intensité minimale représentée par Bmin sur la figure 2 et la valeur d'intensité maximale représentée par BMax sur la figure 2. Puis l'unité de traitement calcule une valeur, dite valeur résiduelle, égale à la moitié de la somme de la valeur Bmin et de la valeur BMax.

L'unité de traitement passe ensuite à l'étape 24.

À l'étape 24, l'unité de traitement 31 additionne ladite valeur résiduelle à la valeur de calibration déjà enregistrée en mémoire, de façon à obtenir une nouvelle valeur, dite valeur constante. En effet, lesdites valeurs corrigées sont déjà corrigées de la valeur de calibration en mémoire.

L'unité de traitement passe ensuite à l'étape 25.

À l'étape 25, l'unité de traitement 31 remplace en mémoire 32 la valeur de calibration par la valeur constante déterminée à l'étape 24, de sorte que la valeur constante devient la nouvelle valeur de calibration. L'unité de traitement revient ensuite à l'étape 21.

Les étapes 21 à 25 sont avantageusement réalisées pour chacune des trois valeurs de projection du vecteur champ magnétique local sur chacun des axes de mesure du magnétomètre.

Le procédé présenté en figure 3 et ci-dessus est une mise en oeuvre possible de l'invention. D'autres procédés peuvent être envisagés de façon avantageuse et conformément à l'invention. En particulier des procédés basés sur les méthodes de calibration présentés ensuite peuvent être envisagés conformément à l'invention, notamment dans les cas de mesures bidimensionnelles ou tridimensionnelles du champ magnétique.

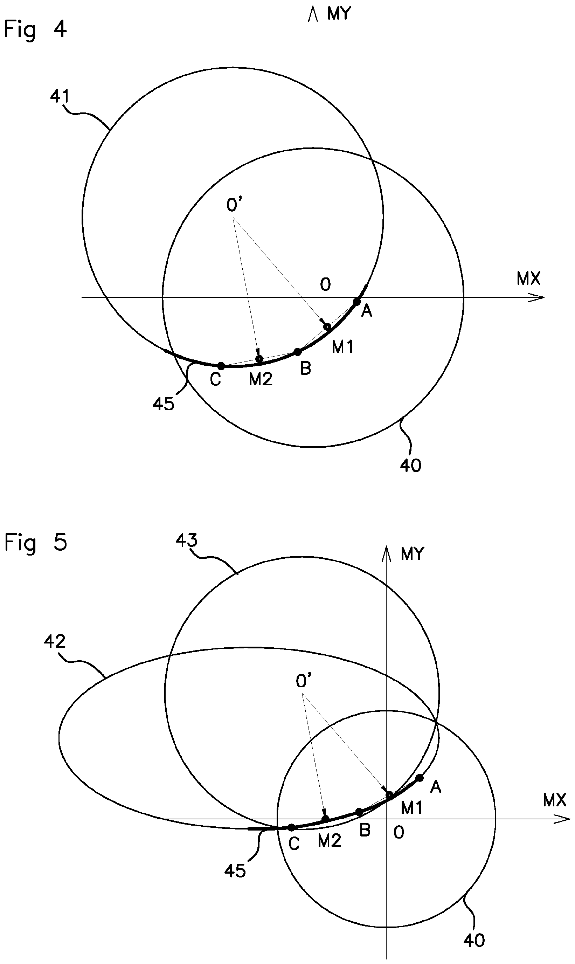

Les figures 4 à 7 présentent des cas particuliers de calibration d'un détecteur de position d'un dispositif selon l'invention placé sur une porte, dans le cas de champs magnétiques locaux perturbés.

Le cercle 40 représente les mesures d'un vecteur de champ magnétique local idéal, sans perturbation, dont l'intensité selon deux axes de mesure MX et MY est représenté dans le référentiel du détecteur de position.

Dans un dispositif selon l'invention on souhaite pouvoir calibrer le détecteur de position, en particulier les mesures du magnétomètre 34, de façon à s'affranchir des effets des perturbations sur la détermination de l'orientation, et plus particulièrement de la variation d'orientation du détecteur de position. Or, pour certains types d'objets surveillés, il n'est pas possible de calibrer le détecteur en lui faisant effectuer une rotation complète par rapport à la direction principale du champ magnétique local. C'est particulièrement le cas des ouvrants pivotants tels que des portes dont la rotation est limitée à des angles généralement compris entre 80 degrés et 180 degrés. Sur les figures 4 à 7 l'amplitude angulaire de déplacement de la porte est représentée par un segment, dit arc de balayage 45.

Pour éliminer l'effet de ces champs parasites, et traduire toute variation de valeurs mesurées par les trois axes du capteur par l'angle de rotation convenable, il faut chercher la transformation de repères qui ramène à la variation de champ magnétique terrestre.

Cette transformation doit être calculée in situ par le capteur pour se calibrer d'une façon transparente de point de vue de l'utilisateur et sans avoir des hypothèses et des données sur la position du détecteur, sur l'endroit où il est placé, son environnement, le sens de rotation, son orientation vis-à-vis du nord...

Conformément à l'invention au moins trois mesures du champ magnétique local correspondant à trois positions (et donc trois orientations) distinctes d'une porte sont réalisées et représentées par les points A, B, C sur l'arc de balayage 45.

En figure 4, un cas classique de perturbation constante d'un champ magnétique selon chaque axe de mesure et quelle que soit l'orientation du détecteur de position, est représenté.

Il faut chercher la transformation qui va ramener le cercle 41 vers le cercle 40, c'est une translation qui va enlever les offsets sur les deux axes x et y, ce qui revient à identifier puis à soustraire sur chaque axe les coordonnées du cercle 41 dans un référentiel centré sur le centre O du cercle 40.

Ces valeurs d'offset étant les coordonnées du centre O' du cercle 41, on cherche à retrouver les coordonnées de ce centre O' à partir d'un nombre de points de l'arc de déplacement possible (arc de balayage 45). Le procédé selon l'invention s'appuie sur la recherche de trois points A, B et C assez éloignés au sens mathématique de la distance, avec une valeur de seuil d'éloignement paramétrable, dite valeur de balayage. Ces points A, B, C sont obtenus lors d'un déplacement lent de la porte.

Le cercle 41 représente les mesures d'un vecteur de champ magnétique local parfait perturbé de façon constante, par exemple par un élément lié au détecteur de position, par exemple une pile du détecteur de position.

Les points A, B, C de mesure appartiennent au cercle 41 dont le centre O' est décalé par rapport au centre O du cercle 40. Le décalage entre le centre O du cercle 40 des mesures d'un champ magnétique idéal et le centre O' du cercle 41 des mesures du champ magnétique local réel correspond aux perturbations du champ magnétique.

Dès lors un dispositif selon l'invention est adapté pour mener un procédé selon l'invention dans lequel les coordonnées du centre O' du cercle 41 des mesures du champ magnétique local réel, qui correspondent auxdites valeurs constantes, sont déterminées. Plus particulièrement, les coordonnées du centre O' du cercle 41 et son rayon peuvent être déterminés par des formules classiques. Ainsi, par exemple, les coordonnées du centre du cercle 41 sont obtenues en résolvant deux équations dont les deux inconnues sont lesdites valeurs constantes.

Les deux équations consistent dans la nullité du produit scalaire des vecteurs *̅O̅'̅M̅1̅*̅ et *̅A̅B̅*̅ où M1 est le milieu du segment [AB], et du produit scalaire des vecteurs *̅O̅'̅M̅*̅2̅ et *̅B̅C̅*̅ où M2 est le milieu du segment [BC].

La correction des valeurs d'intensité mesurées par la valeur de calibration ainsi déterminée revient, géométriquement, à centrer le cercle 41 sur le centre du cercle 40 des mesures du champ magnétique idéal. Les valeurs corrigées seront ainsi toutes sur le cercle 40.

Dans le cas présent le rayon du cercle 41 correspond au rayon du cercle 40, qui correspond à la valeur de la projection du champ magnétique terrestre local dans le plan des axes de mesures MX et MY.

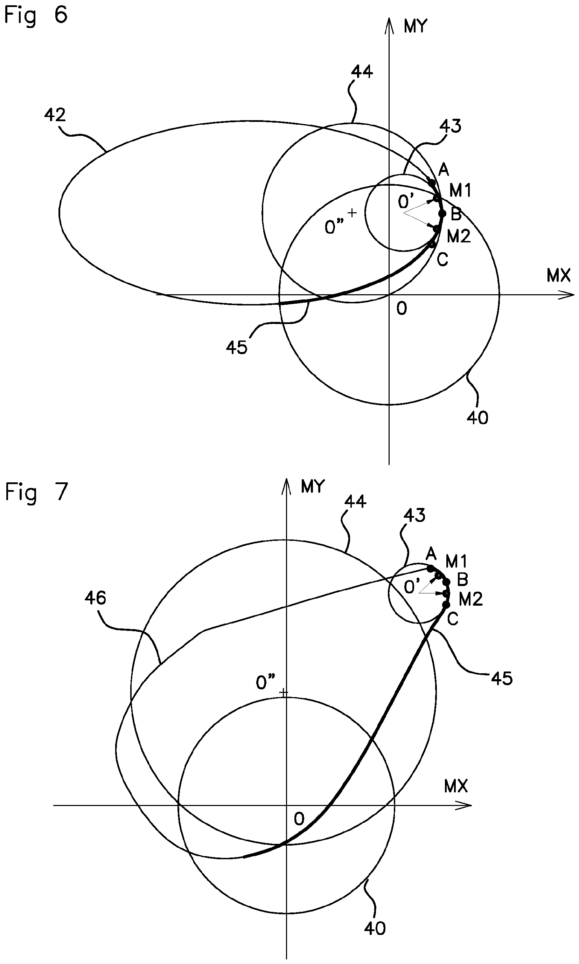

En figures 5 et 6, un cas particulier de perturbation non homogène d'un champ magnétique est représenté.

Dans ce cas particulier, le champ magnétique local est perturbé selon une valeur constante selon chaque axe de mesure MX et MY, comme vu précédemment avec la figure 4, et est en plus perturbé par une variation angulaire de l'intensité du champ magnétique. Dans le cas particulier des figures 5 et 6, le champ magnétique local est intensifié par la perturbation dans la direction de l'axe de mesure MX, de sorte que les mesures du champ magnétique local sont réparties sur une ellipse 42 dans le plan MX-MY.

La présence d'un tel champ se traduit lors de la rotation du capteur (magnétomètre) par la conjonction d'un offset et d'une déformation du cercle en ellipse.

De façon similaire au cas présenté avec la figure 4, la même technique de détermination d'un cercle de calibrage 43 auquel appartiennent les trois points A, B, C est appliquée.

Si les mesures A, B, C sont dans une portion à grand rayon de courbure de l'ellipse, comme représenté en figure 5, la détermination du cercle de calibrage 43, en particulier la détermination du centre O' du cercle de calibrage 43 permet de calibrer le détecteur de façon correcte pour obtenir des mesures de position angulaire du détecteur, et donc de la porte, suffisamment fiables. En effet, les valeurs d'intensité qui seront obtenues seront toujours situées sur l'arc de balayage 45 et seront corrigées par une valeur de calibration correspondant aux coordonnées du centre O' du cercle de calibrage 43. Ainsi, l'ensemble des mesures seront très proche du cercle de calibrage 43.

Le cercle de calibrage 43 ne présente pas le même diamètre que le cercle 40, c'est-à-dire que les valeurs d'intensité mesurées sont plus élevées que celles qui auraient dû être obtenues avec le simple champ magnétique terrestre. Néanmoins, dans l'invention, le magnétomètre est principalement utilisé pour déterminer une orientation du détecteur. Or l'orientation déterminée par une correction de l'ellipse 42 par le cercle de calibrage 43 tel que représenté en figure 5 permet d'obtenir de très bons résultats sur l'orientation angulaire du détecteur.

Ainsi, dans le cas de la figure 5 les résultats présentés dans le tableau I ont été obtenus après une calibration avec le cercle de calibrage 43. Dans la première colonne des valeurs d'angles réels de la porte sont présentées, dans la seconde colonne les valeurs d'angles obtenus via les mesures d'un détecteur de position conforme à l'invention, après calibration selon l'invention, sont présentées.

**Tableau I**

| Angle réel | Angle mesuré |
|---|---|
| 20° | 25° |
| 45° | 40° |
| 90° | 70° |

Ainsi, une telle calibration permet d'obtenir une information fiable sur l'état d'une porte : par exemple un état "ouvert" ou "fermé" malgré des perturbations importantes du champ magnétique. L'information est d'autant plus fiable que des valeurs de seuil permettant de déterminer si une porte est ouverte ou fermée peuvent être adaptées en fonction des mesures effectuées, et donc en fonction du décalage des mesures, de sorte que ce décalage est compensé : par exemple un seuil en deçà duquel une porte est considérée comme fermée peut être fixé à 25° au lieu de 20°, ce qui correspond bien, dans l'exemple précédent à un angle réel de la porte de 20° par rapport à une position de référence.

Dans le cas présenté en figure 6, les mesures A, B, C sont dans une portion à faible rayon de courbure de l'ellipse.

Comme précédemment un cercle de calibrage 43 est déterminé qui comprend les trois points A, B, C. Cependant, comme représenté en figure 6, ce cercle est très éloigné des angles réels et de l'intensité réelle du champ magnétique. Les valeurs corrigées obtenues sur la base d'une calibration effectuée à partir d'un tel cercle de calibrage 43 sont très peu fiables.

À cet effet, l'unité de traitement compare toujours le rayon du cercle de calibrage 43 à deux valeurs de seuil. Si le rayon du cercle de calibrage 43 est compris entre ces deux valeurs de seuil, le cercle de calibrage 43 est conservé. Si le rayon du cercle de calibrage 43 est en deçà ou au-delà de la plage de valeur limitée par ces deux valeurs de seuil, un cercle de calibrage 44 de plus grand rayon est recherché.

L'unité de traitement peut par exemple acquérir et/ou attendre d'avoir acquis des mesures supplémentaires, par exemple dans la zone de rayon de courbure plus élevé de l'arc de balayage 45, de façon à obtenir un cercle de calibrage 44 plus fiable. L'unité de traitement détermine ainsi un nouveau cercle de calibrage 44 et vérifie que :
- toutes les mesures A, B, C et suivantes sont circonscrites dans le nouveau cercle de calibrage 44,
- son rayon se trouve dans la plage déterminée par les valeurs de seuil.

Par ailleurs, avantageusement, lorsque plus de trois points de mesure répondent au critère de distance entre leur valeurs corrigées sur chaque axe de mesure distinctes de la dite valeur de balayage, plusieurs cercles de calibrage passant par des triplets de points peuvent être déterminés. Un cercle de calibrage moyen est ensuite déterminé à partir de ladite pluralité de cercle de calibrage, par exemple par une fonction d'optimisation de distance, et/ou en utilisant une méthode des moindres carrés pour déterminer le centre et le rayon de ce cercle de calibrage moyen. C'est ce cercle de calibrage moyen qui est utilisé pour déterminer les valeurs de calibration selon chaque axe de mesure.

Ainsi, dans le cas de la figure 6 les résultats présentés dans le tableau II ont été obtenus après une calibration avec le nouveau cercle de calibrage 44.

**Tableau II**

| Angle réel | Angle mesuré |
|---|---|
| 20° | 35° |
| 45° | 90° |
| 90° | 170° |

En figure 7, un autre cas particulier de perturbation non homogène d'un champ magnétique est représenté. Dans ce cas particulier, le champ magnétique local est perturbé selon une valeur constante selon chaque axe de mesure MX et MY, comme vu précédemment avec les figures 4, 5 et 6, et est en plus perturbé par une variation angulaire de l'intensité du champ magnétique. Dans le cas particulier de la figure 7, le champ magnétique local est intensifié par la perturbation dans une unique direction, de sorte que les mesures du champ magnétique local sont réparties sur une courbe fermée 46 dont une grande partie est circulaire, et dont une partie est très déformée.

Lorsque l'arc de balayage 45 et les mesures A, B, C sont dans la partie circulaire ou quasi-circulaire de la courbe fermée 46, la même technique peut être appliquée que dans le cas des exemples présentés en figures 4 et 5.

Lorsque l'arc de balayage 45 et les mesures A, B, C sont dans la partie fortement déformée de la courbe fermée 46, comme représenté en figure 7, la même technique que celle appliquée dans le cas de la figure 6 peut être appliquée. En particulier, le cercle de calibrage 43 pouvant être déterminé à partir des mesures A, B, C ne permet pas de réaliser un calibrage fiable du magnétomètre 34 du détecteur de position ; il est donc nécessaire de déterminer un nouveau cercle de calibrage 44 à partir d'autres mesures que A, B, C, sur l'arc de balayage 45.

Ainsi, dans le cas de la figure 7 les résultats présentés dans le tableau III ont été obtenus après une calibration avec le nouveau cercle de calibrage 44.

**Tableau III**

| Angle réel | Angle mesuré |
|---|---|
| 20 | 40 |
| 45 | 100 |
| 90 | 170 |

Les perturbations angulaires du champ magnétique des cas représentées en figures 5, 6, 7 correspondent par exemple à la présence d'un chambranle métallique de porte, de sorte que le champ n'est modifié que lorsque la porte est à proximité du chambranle, c'est-à-dire à proximité d'une position fermée.

L'invention peut faire l'objet de nombreuses autres variantes de réalisation non représentées.

En particulier, la valeur constante peut être déterminée différemment que par la moyenne des valeurs minimale et maximale mesurées. Rien n'empêche par exemple que la valeur constante soit obtenue en effectuant la moyenne de l'ensemble des valeurs d'intensité fournies par le magnétomètre.

En outre, rien n'empêche de prévoir une étape 21 différente, dans laquelle un bouton poussoir doit être actionné pour déclencher le processus de calibration. De même, l'unité de traitement peut attendre de détecter un événement de référence correspondant à un déplacement spécifique du détecteur de position à partir des signaux du magnétomètre.

## Revendications

1. Dispositif domotique comprenant au moins un détecteur de position (30) d'un ouvrant pivotant, ledit détecteur de position comprenant :
- un boîtier,
- un magnétomètre (34) fixé au boîtier et adapté pour fournir des signaux représentatifs d'au moins une valeur, dite valeur d'intensité, instantanée d'intensité d'un champ magnétique local selon au moins un axe, dit axe de mesure, fixe du boîtier,
- une unité de traitement (31) des signaux fournis par le magnétomètre (34),
- une mémoire (32) comprenant, pour chaque axe de mesure, des données représentatives d'une valeur, dite valeur de calibration, prédéterminée d'intensité du champ magnétique local,
**caractérisé en ce que** l'unité de traitement (31) est programmée pour pouvoir:
- enregistrer en mémoire des valeurs d'intensité pour au moins trois positions du boîtier,
- calculer une valeur, dite valeur constante, au moins en fonction d'au moins trois valeurs d'intensité fournies par le magnétomètre pour au moins trois positions distinctes correspondantes du boîtier,
- ne calculer ladite valeur constante que lorsqu'au moins trois valeurs d'intensité fournies par le magnétomètre sont distinctes entre elles d'au moins une valeur, dite valeur de balayage, prédéterminée comprise entre 20 % et 40 % de l'intensité moyenne du champ magnétique terrestre,
- calculer ladite valeur constante en tant que coordonnées du centre d'un cercle, dit cercle de calibrage, des mesures du vecteur de champ magnétique local réel, déterminées pour deux axes de mesures dans un référentiel du magnétomètre à partir desdites valeurs d'intensité,
- remplacer dans la mémoire (32) ladite valeur de calibration par ladite valeur constante.

2. Dispositif selon la revendication 1, **caractérisé en ce que** la valeur de balayage est comprise entre 25 % et 35 % -notamment de l'ordre de 30 %- de l'intensité moyenne du champ magnétique terrestre.

3. Dispositif selon l'une quelconque des revendication 1 ou 2, **caractérisé en ce que** ladite valeur constante est, pour un axe de mesure, égale à la somme:
- de la moyenne de la valeur d'intensité la plus basse et de la valeur d'intensité la plus haute de la pluralité de valeurs d'intensité fournies par le magnétomètre (34), pour cette axe de mesure, pour une pluralité de positions distinctes du boîtier, et
- de la valeur de calibration enregistrée en mémoire (32) pour cet axe de mesure.

4. Dispositif selon l'une des revendications 1 à 3, **caractérisé en ce que** l'unité de traitement (31) est programmée pour calculer, pour chaque axe de mesure, une valeur, dite valeur corrigée, par soustraction de la valeur de calibration à ladite valeur d'intensité instantanée fournie par ledit magnétomètre (34).

5. Dispositif selon l'une des revendications 1 à 4, **caractérisé en ce que** le magnétomètre (34) est adapté pour pouvoir mesurer des variations du champ magnétique terrestre local par une rotation du boîtier dans un plan azimutal.

6. Dispositif selon l'une des revendications 1 à 5, **caractérisé en ce que** le magnétomètre (34) est un magnétomètre trois axes adapté pour fournir des signaux représentatifs de la valeur d'intensité instantanée du champ magnétique local selon trois axes de mesure.

7. Dispositif selon l'une des revendications 1 à 6, **caractérisé en ce que** le détecteur de position (30) comprend en outre des moyens d'émission sans fil (35) de signaux.

8. Dispositif selon la revendication 7, **caractérisé en ce qu'**il comprend en outre une unité centrale adaptée pour recevoir sans fil des signaux émis par un détecteur de position (30).

9. Procédé de calibration d'un détecteur de position (30) d'un ouvrant pivotant, ledit détecteur de position comprenant :
- un boîtier,
- un magnétomètre (34) fixé au boîtier et adapté pour fournir des signaux représentatifs d'au moins une valeur, dite valeur d'intensité, instantanée d'intensité d'un champ magnétique local selon au moins un axe de mesure,
- une unité de traitement (31) des signaux fournis par le magnétomètre (34),
- une mémoire (32) comprenant des données représentatives d'une valeur, dite valeur de calibration, prédéterminée d'intensité du champ magnétique local,
**caractérisé en ce qu'**il comprend des étapes consistant à :
- enregistrer en mémoire des valeurs d'intensité du champ magnétique local pour au moins trois positions du boîtier,
- calculer une valeur, dite valeur constante, en fonction de ladite valeur de calibration et d'au moins trois valeurs d'intensité fournies par le magnétomètre pour au moins trois positions distinctes du boîtier,
- ne calculer ladite valeur constante que lorsqu'au moins trois valeurs d'intensité fournies par le magnétomètre sont distinctes entre elles d'au moins une valeur, dite valeur de balayage, prédéterminée comprise entre 20 % et 40 % de l'intensité moyenne du champ magnétique terrestre,
- calculer ladite valeur constante en tant que coordonnées du centre d'un cercle, dit cercle de calibrage, des mesures du vecteur de champ magnétique local réel, déterminées pour deux axes de mesures dans un référentiel du magnétomètre à partir desdites valeurs d'intensité,
- remplacer dans la mémoire (32) ladite valeur de calibration par ladite valeur constante.

10. Procédé selon la revendication 9, **caractérisé en ce que** la valeur de balayage est comprise entre 25 % et 35 % -notamment de l'ordre de 30 %-de l'intensité moyenne du champ magnétique terrestre.

11. Procédé selon l'une quelconque des revendications 9 ou 10, **caractérisé en ce que** :
- ledit magnétomètre effectue des mesures de l'intensité du champ magnétique selon au moins deux axes, dites axes de mesure, fixes distincts du boîtier,
- l'unité de traitement calcule une valeur constante pour chaque axe de mesure en résolvant au moins deux équations dont les deux inconnues sont lesdites valeurs constantes.

12. Procédé selon l'une des revendications 9 à 11, **caractérisé en ce que** l'unité de traitement :
- calcule, pour une pluralité de positions distinctes du boîtier (36), une valeur, dite valeur de norme, à partir des valeurs d'intensité selon chaque axe de mesure pour cette position, et de la valeur de calibration,
- compare ladite norme à au moins une valeur de seuil prédéterminée enregistrée en mémoire (32).

13. Procédé selon l'une des revendications 9 à 12, **caractérisé en ce qu'**il comprend :
- une étape de fixation du boîtier du détecteur de position (30) audit ouvrant pivotant,
- une étape de déplacement de l'ouvrant pivotant lors de laquelle une pluralité de valeurs d'intensité fournies par le magnétomètre sont enregistrées pour une pluralité de positions distinctes du boîtier.

14. Programme d'ordinateur comprenant des instructions de code de programme pour l'exécution des étapes d'un procédé selon l'une des revendications 9 à 13 lorsque le programme est exécuté sur un ordinateur, notamment sur un dispositif selon l'une des revendications 1 à 8.

## Patentansprüche

1. Hausautomationsvorrichtung umfassend mindestens einen Positionsdetektor (30) eines schwenkbaren Flügels, wobei der Positionsdetektor Folgendes umfasst:
- ein Gehäuse,
- ein an dem Gehäuse befestigtes Magnetometer (34), das dazu geeignet ist, repräsentative Signale zu mindestens einem Wert zu liefern, nämlich einem Intensitätswert, welcher eine momentane Intensität eines lokalen Magnetfeldes entlang mindestens einer festen Achse des Gehäuses, nämlich einer Messachse, angibt,
- eine Verarbeitungseinheit (31) für die von dem Magnetometer (34) gelieferten Signale,
- einen Speicher (32), der für jede Messachse repräsentative Daten eines Wertes, nämlich eines Kalibrierungswertes, umfasst, der die Intensität des lokalen Magnetfeldes vorbestimmt,
**dadurch gekennzeichnet, dass** die Verarbeitungseinheit (31) für die Durchführung der folgenden Schritte konfiguriert ist:
- Abspeichern von Intensitätswerten für mindestens drei Gehäusepositionen im Speicher,
- Berechnen eines Wertes, nämlich eines konstanten Wertes, aus mindestens drei durch das Magnetometer gelieferten Intensitätswerten für mindestens drei entsprechende unterschiedliche Gehäusepositionen,
- Berechnen des konstanten Wertes nur in dem Fall, dass mindestens drei durch das Magnetometer gelieferte Intensitätswerte sich untereinander in mindestens einem vorbestimmten Wert, nämlich dem Scan-Wert, unterscheiden, wobei der vorgegebene Scan-Wert im Bereich zwischen 20 % und 40 % der mittleren Intensität des Erdmagnetfeldes liegt,
- Berechnen des konstanten Wertes als Koordinaten eines Mittelpunkts eines Kreises, nämlich eines Kalibrierungskreises, aus Messwerten des Vektors des realen lokalen Magnetfeldes, welche für zwei Messachsen in einem Referenzrahmen des Magnetometers ausgehend von den Intensitätswerten bestimmt sind,
- Ersetzen des Kalibrierungswertes durch den konstanten Wert im Speicher (32).

2. Vorrichtung nach Anspruch 1, **dadurch gekennzeichnet, dass** der Scan-Wert im Bereich zwischen 25 % und 35 % der mittleren Intensität des Erdmagnetfeldes, insbesondere in der Größenordnung von 30 %, liegt.

3. Vorrichtung nach einem der Ansprüche 1 oder 2, **dadurch gekennzeichnet, dass** der konstante Wert für eine Messachse gleich der Summe aus den folgenden Werten ist:
- dem Mittelwert aus dem niedrigsten Intensitätswert und dem höchsten Intensitätswert aus der Mehrzahl der von dem Magnetometer (34) für diese Messachse für eine Mehrzahl von unterschiedlichen Gehäusepositionen gelieferten Intensitätswerte, und
- dem im Speicher (32) abgespeicherten Kalibrierungswert für diese Messachse.

4. Vorrichtung nach einem der Ansprüche 1 bis 3, **dadurch gekennzeichnet, dass** die Verarbeitungseinheit (31) dazu konfiguriert ist, für jede Messachse einen Wert, nämlich einen korrigierten Messwert, durch Subtraktion des Kalibrierungswertes von dem durch das Magnetometer (34) gelieferten momentanen Intensitätswert zu berechnen.

5. Vorrichtung nach einem der Ansprüche 1 bis 4, **dadurch gekennzeichnet, dass** das Magnetometer (34) dazu geeignet ist, Änderungen des lokalen Erdmagnetfeldes durch eine Drehung des Gehäuses auf einer Azimut-Ebene messen zu können.

6. Vorrichtung nach einem der Ansprüche 1 bis 5, **dadurch gekennzeichnet, dass** das Magnetometer (34) ein dreiachsiges Magnetometer ist, welches dazu geeignet ist, repräsentative Signale der momentanen Intensität des örtlichen Magnetfeldes entlang dreier Messachsen zu liefern.

7. Vorrichtung nach einem der Ansprüche 1 bis 6, **dadurch gekennzeichnet, dass** der Positionsdetektor (30) außerdem kabellose Signalausgabeinstrumente (35) umfasst.

8. Vorrichtung nach Anspruch 7, **dadurch gekennzeichnet, dass** die Vorrichtung außerdem eine Zentraleinheit für den kabellosen Empfang von durch einen Positionsdetektor (30) ausgesendeten Signalen umfasst.

9. Verfahren zur Kalibrierung eines Positionsdetektors (30) eines schwenkbaren Flügels, wobei der Positionsdetektor Folgendes umfasst:
- ein Gehäuse,
- ein an dem Gehäuse befestigtes Magnetometer (34), das dazu geeignet ist, repräsentative Signale zu mindestens einem Wert zu liefern, nämlich einem Intensitätswert, welcher eine momentane Intensität eines lokalen Magnetfeldes entlang mindestens einer Messachse angibt,
- eine Verarbeitungseinheit (31) für die von dem Magnetometer (34) gelieferten Signale,
- einen Speicher (32), der repräsentative Daten eines Wertes, nämlich eines Kalibrierungswertes, umfasst, der die Intensität des lokalen Magnetfeldes vorbestimmt,
**dadurch gekennzeichnet, dass** das Verfahren folgende Schritte umfasst:
- Abspeichern von Intensitätswerten des Magnetfeldes für mindestens drei Gehäusepositionen im Speicher,
- Berechnen eines Wertes, nämlich eines konstanten Wertes, aus dem Kalibrierungswert und mindestens drei durch das Magnetometer gelieferten Intensitätswerten für mindestens drei unterschiedliche Gehäusepositionen,
- Berechnen des konstanten Wertes nur in dem Fall, dass mindestens drei durch das Magnetometer gelieferte Intensitätswerte sich untereinander in mindestens einem vorbestimmten Wert, nämlich dem Scan-Wert, der im Bereich zwischen 20 % und 40 % der mittleren Intensität des Erdmagnetfeldes liegt, unterscheiden,
- Berechnen dieses konstanten Wertes als Koordinaten eines Mittelpunkts eines Kreises, nämlich eines Kalibrierungskreises, aus Messwerten des Vektors des realen lokalen Magnetfeldes, welche für zwei Messachsen in einem Referenzrahmen des Magnetometers ausgehend von den Intensitätswerten bestimmt sind,
- Ersetzen des Kalibrierungswertes durch den konstanten Wert im Speicher (32).

10. Verfahren nach Anspruch 9, **dadurch gekennzeichnet, dass** der Scan-Wert im Bereich zwischen 25 % und 35 % der mittleren Intensität des Erdmagnetfeldes, insbesondere in der Größenordnung von 30 %, liegt.

11. Verfahren nach einem der Ansprüche 9 oder 10, **dadurch gekennzeichnet, dass**
- das Magnetometer Messungen der Intensität des Magnetfeldes entlang mindestens zweier unterschiedlicher fester Achsen des Gehäuses, nämlich der Messachsen, vornimmt,
- die Verarbeitungseinheit einen konstanten Wert für jede Messachse berechnet, indem sie mindestens zwei Gleichungen löst, bei denen die zwei Unbekannten die konstanten Werte sind.

12. Verfahren nach einem der Ansprüche 9 bis 11, **dadurch gekennzeichnet, dass** die Verarbeitungseinheit folgende Schritte ausführt:
- Berechnen eines Wertes, nämlich eines Normwertes, für eine Mehrzahl von unterschiedlichen Positionen des Gehäuses (36) ausgehend von den Intensitätswerten entlang jeder Messachse für diese Position, und ausgehend von dem Kalibrierungswert,
- Vergleichen dieses Normwertes mit mindestens einem im Speicher (32) abgespeicherten vorbestimmten Schwellenwert.

13. Verfahren nach einem der Ansprüche 9 bis 12, **dadurch gekennzeichnet, dass** das Verfahren folgende Schritte umfasst:
- Befestigen des Gehäuses des Positionsdetektors (30) an dem schwenkbaren Flügel,
- Verstellen des schwenkbaren Flügels, sobald eine Mehrzahl von durch das Magnetometer gelieferten Intensitätswerten für eine Mehrzahl von unterschiedlichen Gehäusepositionen abgespeichert ist.

14. Computerprogramm umfassend Instruktionen aus einem Programmcode für die Ausführung der Schritte eines Verfahrens gemäß einem der Ansprüche 9 bis 13, wenn das Programm auf einem Computer, insbesondere auf einer Vorrichtung gemäß einem der Ansprüche 1 bis 8, ausgeführt wird.

## Claims

1. Home automation device comprising at least one position detector (30) for a pivoting opening element, said position detector comprising:
- a housing,
- a magnetometer (34) which is fixed to the housing and adapted to provide signals representing at least one instantaneous intensity value, called the intensity value, of a local magnetic field along at least one fixed axis, called the measurement axis, of the housing,
- a processing unit (31) for processing the signals provided by the magnetometer (34),
- a memory (32) comprising, for each measurement axis, data representing a predetermined intensity value, called the calibration value, of the local magnetic field,
**characterised in that** the processing unit (31) is programmed to be able to:
- store in the memory intensity values for at least three positions of the housing,
- calculate a value, called the constant value, at least as a function of at least three intensity values provided by the magnetometer for at least three corresponding different positions of the housing,
- calculate said constant value only when at least three intensity values provided by the magnetometer are different from one another by at least a predetermined value, called the scanning value, of between 20% and 40% of the average intensity of the geomagnetic field,
- calculate said constant value as coordinates of the centre of a circle, called the calibration circle, of the measurements of the actual local magnetic field vector, determined for two measurement axes in a reference system of the magnetometer starting from said intensity values,
- replacing said calibration value by said constant value in the memory (32).

2. Device according to claim 1, **characterised in that** the scanning value is between 25% and 35% - especially approximately 30% - of the average intensity of the geomagnetic field.

3. Device according to either claim 1 or claim 2, **characterised in that**, for a measurement axis, said constant value is equal to the sum of:
- the average of the lowest intensity value and the highest intensity value of the plurality of intensity values provided by the magnetometer (34), for that measurement axis, for a plurality of different positions of the housing, and
- the calibration value stored in the memory (32) for that measurement axis.

4. Device according to any one of claims 1 to 3, **characterised in that** the processing unit (31) is programmed to calculate, for each measurement axis, a value, called the corrected value, by subtraction of the calibration value from said instantaneous intensity value provided by said magnetometer (34).

5. Device according to any one of claims 1 to 4, **characterised in that** the magnetometer (34) is adapted to be able to measure variations in the local geomagnetic field by a rotation of the housing in an azimuthal plane.

6. Device according to any one of claims 1 to 5, **characterised in that** the magnetometer (34) is a three-axis magnetometer adapted to provide signals representing the instantaneous intensity value of the local magnetic field along three measurement axes.

7. Device according to any one of claims 1 to 6, **characterised in that** the position detector (30) further comprises wireless signal transmitting means (35).

8. Device according to claim 7, **characterised in that** it further comprises a central unit adapted to wirelessly receive signals transmitted by a position detector (30).

9. Method for calibrating a position detector (30) of a pivoting opening element, said position detector comprising:
- a housing,
- a magnetometer (34) which is fixed to the housing and adapted to provide signals representing at least one instantaneous intensity value, called the intensity value, of a local magnetic field along at least one measurement axis,
- a processing unit (31) for processing the signals provided by the magnetometer (34),
- a memory (32) comprising data representing a predetermined intensity value, called the calibration value, of the local magnetic field,
**characterised in that** it comprises steps consisting in:
- storing in the memory intensity values of the local magnetic field for at least three positions of the housing,
- calculating a value, called the constant value, as a function of said calibration value and of at least three intensity values provided by the magnetometer for at least three different positions of the housing,
- calculating said constant value only when at least three intensity values provided by the magnetometer are different from one another by at least a predetermined value, called the scanning value, of between 20% and 40% of the average intensity of the geomagnetic field,
- calculating said constant value as coordinates of the centre of a circle, called the calibration circle, of the measurements of the actual local magnetic field vector, determined for two measurement axes in a reference system of the magnetometer starting from said intensity values,
- replacing said calibration value by said constant value in the memory (32).

10. Method according to claim 9, **characterised in that** the scanning value is between 25% and 35% - especially approximately 30% - of the average intensity of the geomagnetic field.

11. Method according to either claim 9 or claim 10, **characterised in that**:
- said magnetometer performs measurements of the magnetic field intensity along at least two different fixed axes, called measurement axes, of the housing,
- the processing unit calculates a constant value for each measurement axis by solving at least two equations, the two unknowns of which are said constant values.

12. Method according to any one of claims 9 to 11, **characterised in that** the processing unit:
- calculates, for a plurality of different positions of the housing (36), a value, called the normal value, starting from the intensity values along each measurement axis for that position, and from the calibration value,
- compares said normal value with at least one predetermined threshold value stored in the memory (32).

13. Method according to any one of claims 9 to 12, **characterised in that** it comprises:
- a step of fixing the housing of the position detector (30) to said pivoting opening element,
- a step of moving the pivoting opening element, in which a plurality of intensity values provided by the magnetometer are stored for a plurality of different positions of the housing.

14. Computer program comprising program code instructions for the execution of the steps of a method according to any one of claims 9 to 13 when the program is executed on a computer, especially on a device according to any one of claims 1 to 8.
